(19) Europäisches Patentamt
European Patent Office
Office européen des brevets

(11) EP 1 564 592 A1

(12) EUROPEAN PATENT APPLICATION

(43) Date of publication:
**17.08.2005 Bulletin 2005/33**

(51) Int Cl.[7]: **G03F 7/09**, G03F 7/11, G03F 7/20

(21) Application number: **04290429.2**

(22) Date of filing: **17.02.2004**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(71) Applicant: **Freescale Semiconductor, Inc.**
**Austin, Texas 78735 (US)**

(72) Inventors:
- **Patterson, Kyle**
**38190 Froges (FR)**
- **Strozewski, Kirk**
**Round Rock, TX 78664 (US)**

(74) Representative: **Wharmby, Martin Angus**
**Freescale Semiconductor Inc.**
**c/o Impetus IP Limited**
**Grove House**
**Lutyens Close**
**Basingstoke, Hampshire RG24 8AG (GB)**

(54) **Protection of resist for immersion lithography technique**

(57) In an immersion lithography method, the photoresist layer (20) is provided with a shield layer (30) to protect it from degradation caused by contact with the immersion liquid. The shield layer (30) is transparent at the exposure wavelength and is substantially impervious to (and, preferably, insoluble in) the immersion liquid. The shield layer (30) can be formed of a material which can be removed using the same developer as is used to develop the photoresist layer (20) after exposure.

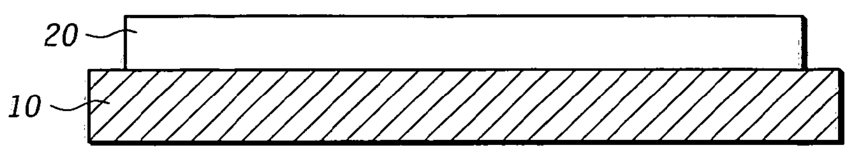


FIG. 2A

EP 1 564 592 A1

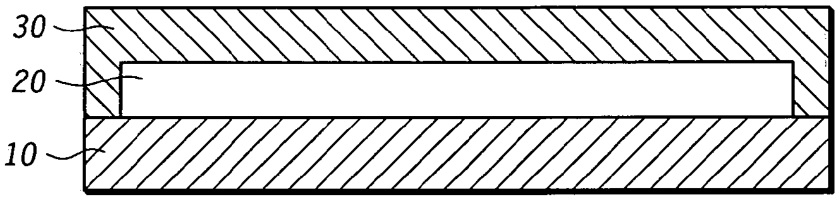


FIG. 2B

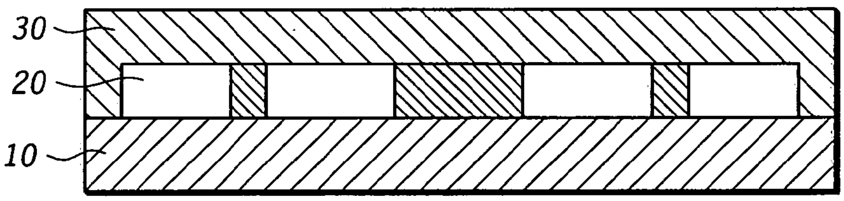


FIG. 2C

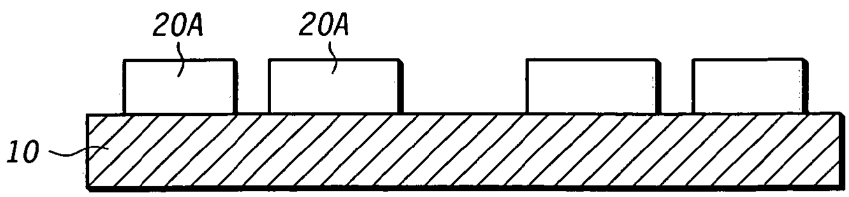


FIG. 2D

## Description

Field of the invention

The present invention relates to the field of optical lithography and, more particularly, to immersion lithography.

Background of the invention

Optical lithography (or photolithography) has been used in the semiconductor industry for over 40 years as a mainstay in the manufacture of integrated semiconductor components and the like. Successive improvements in optical lithography have enabled extremely small features to be printed and fabricated. Unfortunately, this technology is starting to come up against physical barriers which tend to limit further reduction in the scale of the features which can be fabricated. Alternative techniques, such as extreme ultraviolet lithography, have been proposed. However, these alternative technologies are not yet ready for use.

The Rayleigh equation defines the minimum line width, LW, that can be printed with optical lithography, as follows:

$$LW = \frac{k\lambda}{NA}$$

where k is the process factor, $\lambda$ is the wavelength used in the photolithographic process, and NA is the numerical aperture of the exposure lens system.

The process factor, k, depends upon a number of variables in the photolithography process but is considered to have a practical lower limit of 0.25.

Currently, argon fluoride (ArF) Excimer lasers, with a wavelength of 193 nm, are used in photolithography. Fluorine ($F_2$) Excimer lasers ($\lambda$=157nm) have also been proposed. Many are reluctant to invest in the equipment needed to use Fluorine ($F_2$) Excimer lasers ($\lambda$=157nm) given that this equipment is liable to be of use for only a limited period of time.

It has been suggested that a numerical aperture, NA, as high as 0.93 could be obtained in a photolithographic system in an ArF system ($\lambda$=193nm) which, based on the above Rayleigh equation, would make a line width of 52nm achievable. In theory, the maximum achievable value for numerical aperture is 1 in systems where air is the medium between the lens and the wafer, giving a smallest-possible line width in ArF systems of just over 48 nm. However, it has been predicted that line widths of 45nm and below will be required by 2007.

Recently another technique, immersion lithography, has been proposed which can improve the resolution of optical lithography processes down to smaller scales than hitherto. Immersion lithography increases resolution by inserting an immersion medium, generally a liquid, between the optical system used in the photolithographic patterning process and the wafer being processed, in order to increase the numerical aperture of the optical exposure system.

Typically, in a projection exposure system an immersion liquid is inserted between the final lens element and the wafer to be patterned. There are two main approaches: ether the whole wafer stage is flooded with the immersion liquid or a meniscus (a few millimetres thick) is trapped between the final lens element and the wafer.

The numerical aperture, NA, of the optical projection system can be calculated according to the following equation:

$$NA = \eta \sin \theta$$

where $\eta$ is the refractive index of the medium between the lens and the wafer and $\theta$ is the acceptance angle of the lens. It will be seen that by selecting the inserted medium to have a higher refractive index than air at the exposure wavelength the numerical aperture of the system can be increased.

In the case of immersion lithography using ArF systems ($\lambda$=193 nm) the leading candidate for an immersion medium is water, typically de-ionized water. The refractive index of deionized water is 1.44 which, if used as the immersion liquid in an ArF system, would give a potential line width of approximately 33 nm.

However, if a photoresist film is immersed in water many deleterious effects can ensue: leeching of ionic materials from the photoresist film, swelling of the resist, altered diffusion of remaining materials within the resist matrix, etc. These problems are particularly acute in the case of use of de-ionized water. These difficulties are likely to lead to a need to develop new photoresist materials leading to delays in introduction of immersion lithography technology or, at the least, there will be a reduction in the resolution that this technology could achieve.

For immersion media other than water it may also be the case that contact between the immersion liquid and

the photoresist will degrade the properties of the photoresist.

It is to be understood that, in the present document, references to an "immersion medium" or "immersion liquid" denote a medium or liquid that is present between the lens and wafer in an optical lithography system. The word "immersion" should not be taken to require that the whole equipment (or even the wafer in its entirety) be immersed or submerged in the medium or liquid in question, although this may occur in some cases.

The preferred embodiments of the present invention enable an immersion lithography technique to be applied while substantially avoiding undesirable effects on the photoresist film caused by contact with the immersion medium.

## Summary of the invention

The present invention provides an immersion lithography method as described in the accompanying claims.

The present invention further provides an intermediate product as described in the accompanying claims, for exposure in an immersion lithography process.

## Brief description of the drawings

The above and other features and advantages of the present invention will become clear from the following description of preferred embodiments thereof, given by way of example, and illustrated by the accompanying drawings, in which:

Fig.1 is a flow diagram indicating the main steps in an immersion lithography method according to one preferred embodiment of the present invention; and

Fig.2 is a diagram indicating the structure of the wafer at different stages in the method of Fig.1.

## Detailed description of the preferred embodiments

A preferred embodiment of the immersion lithography method according to the present invention will now be described with reference to Figs.1 and 2.

As indicated in the flow diagram of Fig.1, step 1 in the method is the creation of a photoresist layer 20 on a substrate 10. (It is to be noted that the substrate 10 may be a blank wafer or it may have already been subjected to photolithographic patterning to create particular features.) The resultant structure is illustrated schematically in Fig.2A.

The photoresist layer 20 can be formed on the substrate 10 in any convenient manner. Typically, if the substrate is a wafer, the wafer will first be cleaned and primed, a barrier layer will be formed thereon, the photoresist will be formed thereon by spin coating using well-known techniques, then the photoresist will be soft baked to remove undesirable traces of solvent. Typically at the periphery of the photoresist layer several millimetres of that layer are removed ("edge bead removal"). Details of these processes are well-known to the person skilled in the art and can be found, for example, at the "photolithography" page of the website at http:/www.ee.washington.edu.

Next, as shown at step 2 of Fig.1, a shield or capping layer 30 is formed over the photoresist layer 20 by any suitable process to yield the structure illustrated in Fig.2B. Typically, it is convenient to form the shield layer 30 on the photoresist layer using techniques that are employed for forming top anti-reflective coatings (TARC), which will in general include a baking step after coating of the shield layer material.

Advantageously, the shield layer 30 is formed so as to cover substantially all the free surfaces of the photoresist layer, notably the top and side surfaces as shown in Fig.2B. If edge bead removal is performed subsequent to the formation of the shield layer 30 then, preferably, the amount of removed material is smaller than that removed in the earlier edge bead removal process performed on the photoresist layer 20, so as to ensure that a portion of the shield layer 30 remains covering the side surfaces of the photoresist layer 20.

The substrate 10 bearing the photoresist 20 now protected by the shield layer 30 is aligned relative to an optical lithography exposure system, an immersion medium is provided between the exposure lens and the shield layer 30, and the exposing radiation is switched on (step 3 of Fig.1). Well-known stepper or scanner devices can be used to displace the substrate 10 relative to the exposing optical system (or vice versa) during the exposure, as necessary.

It will be seen that, according to the preferred embodiment of the present invention, a shield layer is formed over the photoresist layer before contact between the photoresist layer and the immersion medium. The shield layer 30 is formed from a material that is optically transparent at the exposure wavelength and which is substantially impervious to, and preferably substantially insoluble in, the immersion medium. Thus, the exposing radiation exposes the photoresist through the shield layer 30 to yield the structure illustrated in Fig.2C. Moreover, the shield layer 30 prevents deleterious effects that would otherwise be produced on the photoresist layer 20 by the immersion medium.

By capping the photoresist with a shield layer that is substantially impervious to the immersion medium, the

immersion lithography method of the preferred embodiment avoids contact between the photoresist and the immersion medium, thus preventing degradation in the properties of the photoresist. This allows conventional photoresist materials to be used even in the new immersion lithographic processes, enabling a more rapid introduction of this technology.

It is preferred to use for the shield layer 30 a material that is substantially insoluble in the immersion medium. A partially-soluble material could be used, but the solubility of the shield layer material in the immersion medium would need to be sufficiently low to avoid the photoresist layer becoming exposed to the immersion medium before the photolithographic process has been completed.. Moreover, if the shield layer material has a rate of dissolution in the immersion medium that is too rapid then there would be a danger that the lens element would become coated in the dissolved shield layer material, inhibiting accurate patterning of the photoresist.

Fig.2C illustrates the case of a positive photoresist: the dark areas in Fig.2C represent areas which have been exposed to the exposing radiation, the light areas represent regions which have been hidden from the exposing radiation by the lithographic mask. It is to be understood that the present invention is applicable in general to positive and negative photoresists.

Once the photoresist layer 20 has been exposed, the substrate 10 is removed from the exposure apparatus. In general, the exposed photoresist will now be subjected to a post-baking step. If the shield layer 30 cannot be removed using the developer fluid normally used to develop the exposed photoresist layer 20, then a step 3a is included in the method so as to remove the shield layer. The shield layer 30 can be removed using any suitable chemical agent or physical process which leaves the underlying photoresist substantially unaffected.

Advantageously, the shield layer 30 is formed of a material that can readily be removed using the same developer as is used to develop the exposed photoresist layer 20. Thus, in a single step (step 4 of Fig.1) the photoresist layer 20 is developed and the shield layer 30 is also removed. This avoids an excessive increase in the number of steps involved in the photolithographic fabrication process and associated increased costs and waste products for disposal.

After the shield layer 30 and photoresist layer 20 have been removed this leaves the substrate 10 bearing patterned photoresist 20a as illustrated in Fig.2D.

The material to be used to form the shield layer 30 is chosen dependent on the exposure wavelength and the immersion medium used in the immersion lithography process. A suitable material is one that is transparent at the exposure wavelength and is substantially impervious to (and, preferably, substantially insoluble in) the immersion liquid.

The material used for the shield layer 30 may also be chosen dependent on the developer to be used in developing the photoresist, so that this shield layer material may be removed using the same developer as that used to develop the photoresist after exposure. This cuts down on the overall number of steps required in the lithographic process. Moreover this ensures that the developed photoresist 20a will not be damaged by the process used for removing the shield layer 30.

Clearly, the shield layer material must also be one which itself has substantially no deleterious effects on the photoresist material.

The vast majority of modern photoresists are chemically-amplified resists that can be developed using an aqueous solution of tetramethylammonium hydroxide (TMAH) as the developer solution. This TMAH developer solution is basic (high pH).

When seeking a shield layer material which can readily be removed by the developer, it is relatively straightforward to select a suitable material for use at 157nm exposure wavelengths because the properties of the typical immersion medium (a fluorinated solvent) are significantly different from those of the typical developer (an aqueous solution of TMAH). Therefore, any polymer that offers high transparency at 157nm as well as solubility in basic aqueous solutions will likely fulfil the requirements of the shield layer.

However, at 193 nm exposure wavelengths the choice of shield layer material is more difficult because the immersion medium typically is water and the developer typically is an aqueous solution of TMAH. Thus, in the latter case what is required is a shield layer material whose solubility is pH dependent. Examples of suitable shield layer materials for use at this exposure wavelength include a zwitterionic polymer or co-polymer that is optically transparent at 193nm; a crosslinked polymer film, optically transparent at 193nm, that is susceptible to rapid base hydrolysis to induce aqueous solubility; etc.

It is to be noted that the present invention is applicable to immersion lithography processes involving non-chemically-amplified photoresists as well as to processes involving chemically-amplified photoresists. Moreover the present invention is not limited with regard to the exposure wavelength (365nm, 248nm, 193nm, 127nm, etc.) or associated technology (I-line, deep UV, etc.) used in the immersion lithography process. More specifically, the use of optical wavelengths is not a requirement.

To take one specific example, consider the case of an APEX photoresist (proposed by IBM) that is to be exposed in an immersion lithography process performed at 248nm, in which water is the immersion liquid. It is desired to used an 0.26N TMAH developer solution to develop the photoresist once it is exposed. In such a case, it is advantageous to use for the shield layer a co-polymer of 4-hydrosystyrene and 4-vinylaniline. The nominal structure of this

co-polymer is indicated below.

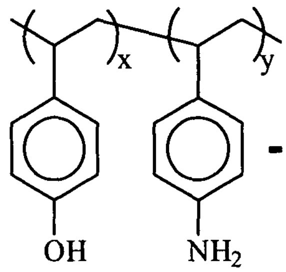

However, this co-polymer does not exist in the nominal form, instead it exists in a zwitterionic form due to acid-based interactions between the monomer units. The zwitterionic form is illustrated below.

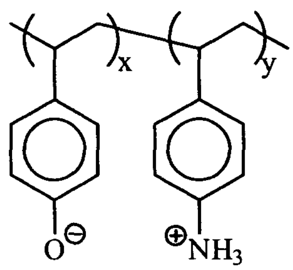

In a neutral pH environment a film formed from this co-polymer is substantially insoluble in and substantially impervious to water. Thus, a film formed of this co-polymer would shield a photoresist from water, in the case where water is used as the immersion liquid in this immersion lithography process.

In a high or low pH environment this co-polymer is soluble. The TMAH developer solution has a relatively high pH and so can remove a film of this co-polymer as well as developing the exposed photoresist.

A shield layer 30 of this co-polymer of 4-hydroxystyrene and 4-vinylaniline can be formed on a photoresist layer 20 by coating the photoresist layer 20 with the oxalate salt of the co-polymer, from water, in a manner similar to that used when forming TARC films (see, for example, "Spin-on application of top-side A/R coatings", by Brian Head, in Solid State Technology June, 2003). After the oxalate salt has been coated on the photoresist layer 20, a baking step is performed which decomposes the oxalate salt into the water-insoluble co-polymer as illustrated below.

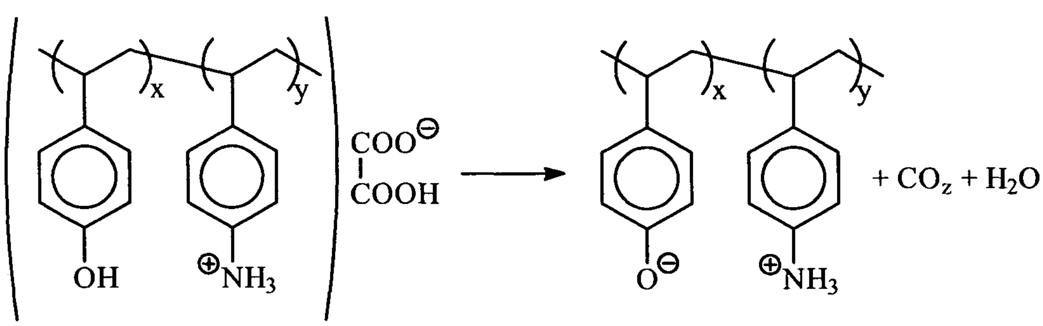

Water Soluble
Oxalate Salt

Zwitterionic Copolymer

Typically the baking step that decomposes the oxalate salt will involve baking the sample at 150°C for 60 seconds.

In the above process, it is convenient to prepare the shield layer material initially as an aqueous solution,

because this facilitates coating of the photoresist layer 20. After coating, the shield layer material can be converted to a water-insoluble form by any suitable chemical or physical process (during the post-coating baking step in the above example).

The above-mentioned zwitterionic copolymer is not sufficiently transparent to be used at exposure wavelengths of 193nm or shorter. However, the above-described approach can be extended to shorter wavelengths by replacing the acid and base monomers with alternate monomers that are transparent at the wavelength of interest.

Although the present invention has been described with reference to a preferred embodiment thereof, it is to be understood that the invention is not limited with reference to the details of that embodiment. More particularly, the person skilled in the art will realize that changes and adaptations can be made in that embodiment without departing from the scope of the present invention as defined in the accompanying claims.

For example, the above discussion of photoresists is a simplified one. The skilled person will readily appreciate that the photoresists can contain additional components (such as photoacid generators, photobase generators, quenchers, dissolution inhibitors, amplification catalysts, etc.) that have not been specifically mentioned above.

Similarly, the discussion of the immersion lithography process has been simplified. The skilled person will readily appreciate that additional steps and measures will generally be applied in the immersion lithography process, such as measures to ensure that no bubbles are formed in the immersion liquid, a rinsing step to ensure that developer is rinsed from the developed photoresist, etc.

Moreover, although the above-described preferred embodiment relates to an immersion lithography process in which the immersion medium is water, the present invention is not limited to use of this particular immersion liquid or even to the use of liquids - immersion media in other forms may be used, for example gases.

## Claims

1. An immersion lithography method in which an immersion medium is inserted between the optical exposure system and a photoresist layer (20) to be exposed and, after exposure, the photoresist layer is developed using a developer, the method comprising the step of providing the photoresist layer (20) with a shield layer (30) to prevent contact between the photoresist layer (20) and the immersion medium, said shield layer being transparent at the exposure wavelength and being substantially impervious to the immersion medium.

2. An immersion lithography method according to claim 1, wherein the shield layer (30) is formed of a material that is substantially insoluble in the immersion medium.

3. An immersion lithography method according to claim 1 or 2, wherein the shield layer (30) is formed of a material that is removed by the developer.

4. An immersion lithography method according to claim 3, wherein the immersion liquid is water, the developer is tetramethylammonium hydroxide and the shield layer (30) is formed of a material having pH-dependent solubility.

5. An immersion lithography method according to claim 4, and comprising the step of providing the photoresist layer (20) with the shield layer (30) by coating the photoresist layer (20) with the shield layer material in a watersoluble form, then applying a chemical or physical process to render the shield layer substantially insoluble in water.

6. An intermediate product for exposure in an immersion lithography process, the product consisting of a substrate (10) bearing a photoresist layer (20), the surface of the photoresist layer (20) remote from the substrate (10) being covered by a shield layer (30) which is transparent at the exposure wavelength used in the immersion lithography process and substantially impervious to the immersion medium.

7. The intermediate product of claim 6, wherein the shield layer material is chosen such that it is substantially insoluble in the immersion medium.

8. The intermediate product of claim 6 or 7, wherein the shield layer material is chosen such that a common developer can remove the shield layer (30) and develop the photoresist layer (20).

9. The intermediate product of claim 8, wherein the shield layer is formed of a material having pH-dependent solubility.

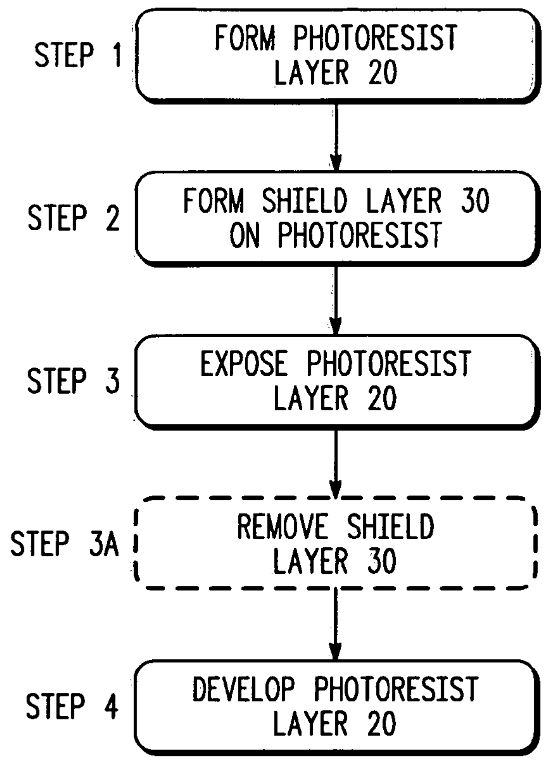
STEP 1
FORM PHOTORESIST LAYER 20
STEP 2
FORM SHIELD LAYER 30 ON PHOTORESIST
STEP 3
EXPOSE PHOTORESIST LAYER 20
STEP 3A
REMOVE SHIELD LAYER 30
STEP 4
DEVELOP PHOTORESIST LAYER 20

*FIG. 1*

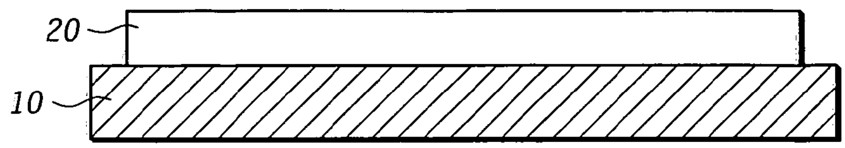


FIG. 2A

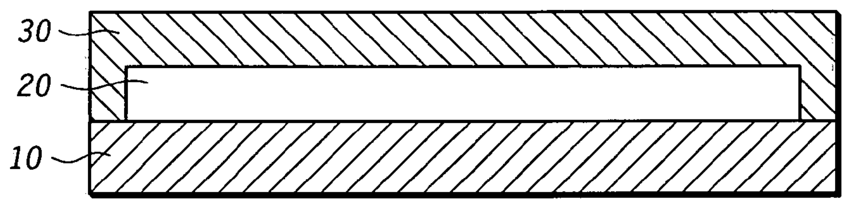


FIG. 2B

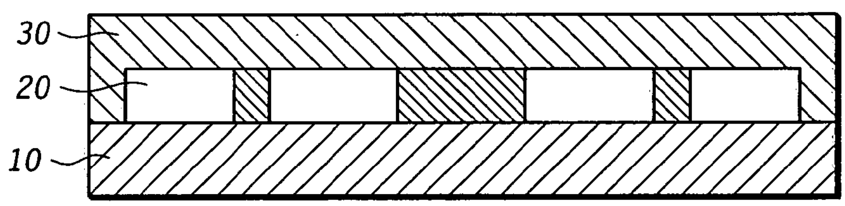


FIG. 2C

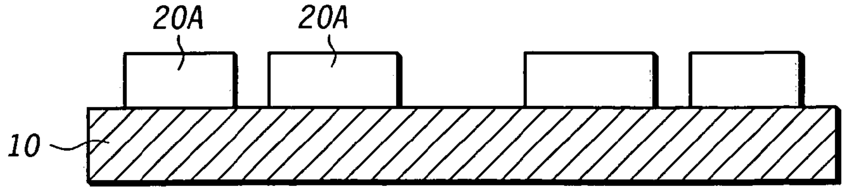


FIG. 2D

European Patent Office

# EUROPEAN SEARCH REPORT

Application Number
EP 04 29 0429

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2001/044077 A1 (TAN ZOILO CHEN HO) 22 November 2001 (2001-11-22) * paragraphs [0008], [0014] - [0020]; figure 2 * | 6-8 | G03F7/09 G03F7/11 G03F7/20 |
| X | US 5 326 675 A (NIKI HIROKAZU ET AL) 5 July 1994 (1994-07-05) * column 3, lines 6-34 * * column 7, lines 34-42 * * column 19, lines 5-65 * | 6 | |
| X | US 2002/076626 A1 (MONTGOMERY CECILIA ANNETTE ET AL) 20 June 2002 (2002-06-20) * paragraphs [0009] - [0011], [0031] * | 6 | |
| X | PATENT ABSTRACTS OF JAPAN vol. 0184, no. 23 (P-1783), 8 August 1994 (1994-08-08) & JP 6 130657 A (MITSUBISHI RAYON CO LTD; others: 01), 13 May 1994 (1994-05-13) * abstract * | 6 | TECHNICAL FIELDS SEARCHED (Int.Cl.7) |
| A | SWITKES M ET AL: "Extending optics to 50 nm and beyond with immersion lithography" J. VAC. SCI. TECHNOL. B, MICROELECTRON. NANOMETER STRUCT. (USA), JOURNAL OF VACUUM SCIENCE & TECHNOLOGY B (MICROELECTRONICS AND NANOMETER STRUCTURES), NOV. 2003, AIP FOR AMERICAN VACUUM SOC, USA, vol. 21, no. 6, September 2003 (2003-09), pages 2794-2799, XP002285381 ISSN: 0734-211X * page 2794, column 2, line 27 - page 2795, column 1, line 2 * * page 2797, column 2, lines 2-15 * * page 2798, column 2, line 34 - page 2799, column 1, line 3 * | 1,6 | G03F |

-/--

The present search report has been drawn up for all claims

| Place of search | Date of completion of the search | Examiner |
|---|---|---|
| The Hague | 22 June 2004 | Müller-Kirsch, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

2
EPO FORM 1503 03.82 (P04C01)

European Patent Office

# EUROPEAN SEARCH REPORT

Application Number
EP 04 29 0429

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 4 346 164 A (LOEBACH ERNST W ET AL) 24 August 1982 (1982-08-24) * column 3, line 57 - column 4, line 13 * ----- | 1,6 | |
| E | US 2004/075895 A1 (LIN BURN JENG) 22 April 2004 (2004-04-22) adressing several problems in immersion lens lithography: PHOTORESIST outgassing problem, fluid circulation, fluid filtering for maintaining fluid particle free, temperature management, circulation of * paragraph [0026] * ----- | 1,6 | |
| | | | TECHNICAL FIELDS SEARCHED (Int.Cl.7) |

The present search report has been drawn up for all claims

| Place of search | Date of completion of the search | Examiner |
|---|---|---|
| The Hague | 22 June 2004 | Müller-Kirsch, L |

2

EPO FORM 1503 03.82 (P04C01)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................
& : member of the same patent family, corresponding document

## ANNEX TO THE EUROPEAN SEARCH REPORT ON EUROPEAN PATENT APPLICATION NO. EP 04 29 0429

This annex lists the patent family members relating to the patent documents cited in the above-mentioned European search report.
The members are as contained in the European Patent Office EDP file on
The European Patent Office is in no way liable for these particulars which are merely given for the purpose of information.

22-06-2004

| Patent document cited in search report | Publication date | Patent family member(s) | Publication date |
|---|---|---|---|
| US 2001044077 A1 | 22-11-2001 | AU 4246500 A | 02-11-2000 |
| | | WO 0063747 A1 | 26-10-2000 |
| | | US 2002071995 A1 | 13-06-2002 |
| | | US 2002076626 A1 | 20-06-2002 |
| US 5326675 A | 05-07-1994 | JP 3281053 B2 | 13-05-2002 |
| | | JP 5216244 A | 27-08-1993 |
| | | KR 9506953 B1 | 26-06-1995 |
| | | US RE35821 E | 09-06-1998 |
| US 2002076626 A1 | 20-06-2002 | US 2002071995 A1 | 13-06-2002 |
| | | US 2001044077 A1 | 22-11-2001 |
| | | WO 03046658 A1 | 05-06-2003 |
| | | EP 1405142 A1 | 07-04-2004 |
| | | WO 03007081 A1 | 23-01-2003 |
| | | AU 4246500 A | 02-11-2000 |
| | | WO 0063747 A1 | 26-10-2000 |
| JP 6130657 A | 13-05-1994 | NONE | |
| US 4346164 A | 24-08-1982 | US 4509852 A | 09-04-1985 |
| US 2004075895 A1 | 22-04-2004 | NONE | |

EPO FORM P0459

For more details about this annex : see Official Journal of the European Patent Office, No. 12/82